Europäisches Patentamt

European Patent Office

Office européen des brevets

(19)

(11) Veröffentlichungsnummer: **0 009 712**
**B1**

(12) **EUROPÄISCHE PATENTSCHRIFT**

(45) Veröffentlichungstag der Patentschrift:
20.01.82

(51) Int. Cl.³: **G 01 G 3/145**, G 01 R 17/02

(21) Anmeldenummer: 79103492.9

(22) Anmeldetag: 17.09.79

(54) Verfahren zur Korrektur der Empfindlichkeit der Auswägeeinrichtung von elektrischen Wägeanlagen und Schaltungsanordnung zur Ausübung des Verfahrens.

(30) Priorität: 27.09.78 DE 2842041

(43) Veröffentlichungstag der Anmeldung:
16.04.80 Patentblatt 80/8

(45) Bekanntmachung des Hinweises auf die Patenterteilung:
20.01.82 Patentblatt 82/3

(84) Benannte Vertragsstaaten:
AT BE CH FR GB IT LU NL SE

(56) Entgegenhaltungen:
DE-A-1 449 946
DE-A-2 612 399
DE-B-2 601 151
GB-A-1 471 905
US-A-3 847 017

(73) Patentinhaber: SIEMENS AKTIENGESELLSCHAFT Berlin und München, Postfach 22 02 61, D-8000 München 22 (DE)

(72) Erfinder: Fritz, Harald, Ing.grad., Hebelstrasse 5, D-7517 Waldbronn 3 (DE)
Erfinder: Schröder, Heinrich, Dipl.-Ing., Schneidemühlerstrasse 43b, D-7500 Karlsruhe (DE)

## Verfahren zur Korrektur der Empfindlichkeit der Auswägeeinrichtung von elektrischen Wägeanlagen und Schaltungsanordnung zur Ausübung des Verfahrens

Die Erfindung bezieht sich auf ein Verfahren zur Korektur der Empfindlichkeit der Auswägeeinrichtung von elektrischen Wägeanlagen aufgrund eines Vergleichs eines von einem Referenzsignal verursachten Ausgangssignals der Auswägeeinrichtung mit einem Sollwert.

In elektromechanischen Wägeanlagen müssen die empfindlichkeitsbestimmenden Elemente eine hohe Langzeitkonstanz besitzen, weil die Waagen über die gesamte, drei bis vier Jahre dauernde Eichperiode innerhalb der Verkehrsfehlergrenzen liegen müssen. Massnahmen zur Temperaturkompensation der Leitungen zwischen Messort und Auswägeelektronik sowie zur Stabilisierung von Verstärkungsfaktoren usw. sind deshalb relativ aufwendig. Bisher war die Korrektur der Empfindlichkeit innerhalb einer Eichperiode ohne die Verwendung von Eichgewichten praktisch nicht durchzuführen, weil die Kosten für ein dazu notwendiges, ensprechend stabiles und gleichzeitig zuverlässiges elektrisches Vergleichsnormal höher waren als die Aufwendungen für die Langzeitkonstanz der Auswägeeinrichtung.

Die Empfindlichkeit der Auswägeelektronik wird üblicherweise über ein in den Messkreis eingespeistes Referenzsignal überprüft, siehe dazu DE-OS 26 12 399. Eine Korrektur der Empfindlichkeit aufgrund dieses Prüfsignals ist jedoch nicht ratsam, weil Veränderungen in den das Referenzsignal bestimmenden Bauelementen nicht auszuschliessen sind und Fehler, die aufgrund einer Korrektur mit einem fehlerhaften Normal auftreten, nicht erkannt werden.

Der Erfindung lag die Aufgabe zugrunde, ein eingangs erwähntes Verfahren so zu verbessern, dass ein fehlerhaftes Referenzsignal erkannt wird und damit Folgen einer Fehlkorrektur vermieden werden.

Das Verfahren zur Korrektur der Empfindlichkeit der Auswägeeinrichtung von elektrischen Wägeanlagen aufgrund eines Vergleichs eines von einem Referenzsignal verursachten Ausgangssignales der Auswägeeinrichtung mit einem Sollwert ist gemäss der Erfindung dadurch gekennzeichnet, dass auf den ersten Vergleich ein weiterer Vergleich eines durch ein vom ersten unabhängiges zweites Referenzsignal hervorgerufenen Ausgangssignales der Auswägeeinrichtung mit dem Sollwert erfolgt und die Auswägeeinrichtung blockiert wird, wenn das vom zweiten Referenzsignal hervorgerufene Ausgangssignal die auf dem ersten Vergleich beruhende Korrektur nicht bestätigt. Auf diese Weise kontrollieren sich beide Referenzsignale gegenseitig. Fehlkorrekturen infolge Weglaufens eines der beiden Referenzsignalgeber sind damit ausgeschaltet.

Die Korrektur erfolgt also in zwei zeitlich voneinander getrennten Schritten. In einem ersten Schritt wird über ein Referenzsignal die Empfindlichkeitsabweichung der Auswägeeinrichtung ermittelt und mittels geeigneter Massnahmen, beispielsweise Nachstellen des Verstärkungsgrades eines Verstärkers, korrigiert. In einem zweiten, unmittelbar an den ersten anschliessenden Schritt wird die korrigierte Empfindlichkeit mittels eines zweiten Referenzsignals, das nicht mit den gleichen Bauelementen wie das erste erzeugt wird, überprüft. Liegt danach die Abweichung von dem bei der Eichung festgelegten Sollwert innerhalb der zulässigen Grenzen, so wird die Korrektur bestätigt. Ist die Abweichung jedoch grösser, so wird der weitere Betrieb der Wägeanlage blockiert.

Die Korrektur kann entweder manuell über Knopfdruck, z.B. in Verbindung mit einer Kontrolle der Nullstellung, oder auch automatisch, z.B. in den Wägepausen, gesteuert werden. Sie kann auch abhängig von einer verstrichenen Zeit seit der letzten Korrektur, von an der Wägeanlage auftretenden Temperaturgradienten oder innerhalb automatischer Nullstellzyklen vorgenommen werden. Gute Ergebnisse des Verfahrens nach der Erfindung werden erzielt, wenn ein langzeitstabiles Bauelement mit hoher Zuverlässigkeit als Referenzsignalgeber verwendet wird. Zur Zeit kann ein künstlich gealterter Drahtwickelwiderstand aus temperaturkompensiertem Widerstandsmaterial als ein solches Bauelement betrachtet werden.

Eine Schaltungsanordnung zur Ausübung des Verfahrens weist als Merkmale einen Referenzsignalgeber auf, der mit den Eingangsklemmen einer Auswägeeinrichtung verbunden ist. Der Ausgang der Auswägeeinrichtung ist an Eingänge eines Istwert-Speichers und einer Anzeigeeinheit angeschlossen. Vergleichseingänge eines Komparators sind mit Ausgängen des Istwert-Speichers bzw. eines Sollwert-Speichers verbunden. Entscheidungsausgänge des Komparators für ungleichen Ist- und Sollwert sind an einen Korrektureingang der Auswägeeinrichtung und für ungleichen korrigierten Istwert und Sollwert an einen Sperreingang der Anzeigeeinheit gelegt. Innerhalb des Referenzsignalgebers befindliche Umschalter sind mit einem Steuersignalausgang einer Steuereinheit verbunden.

Ein Ausführungsbeispiel eines Referenzsignalgebers besteht zweckmässig aus einer Widerstandsbrückenschaltung mit je zwei zur Messdiagonalen symmetrischen Brückenhälften aus je drei in Serie geschalteten Widerständen. Die Anschlusspunkte der jeweils zweiten Widerstände beider Hälften sind über je einen Umschalter an eine Speisequelle anschliessbar. Der Messdiagonalen wird das Referenzsignal entnommen.

Ein zweites Ausführungsbeispiel eines Referenzsignalgebers besteht aus einer Widerstandsbrückenschaltung mit zwei zur Messdiagonalen symmetrischen Brückenhälften aus je vier in Serie geschalteten Widerständen. Die Anschlusspunkte der zweiten und dritten Widerstände beider Brückenhälften sind über je einen Umschalter und zusätzliche Abgleichwiderstände an die Speisequelle anschliessbar. Der Messdiagonalen wird das Referenzsignal entnommen.

Die Erfindung wird anhand einer Zeichnung mit drei Figuren erläutert.

In Figur 1 ist eine Schaltungsanordnung zur Ausübung des Verfahrens nach der Erfindung als Blockschaltbild dargestellt.

Die Figuren 2 und 3 zeigen jeweils ein Ausführungsbeispiel eines Referenzsignalgebers.

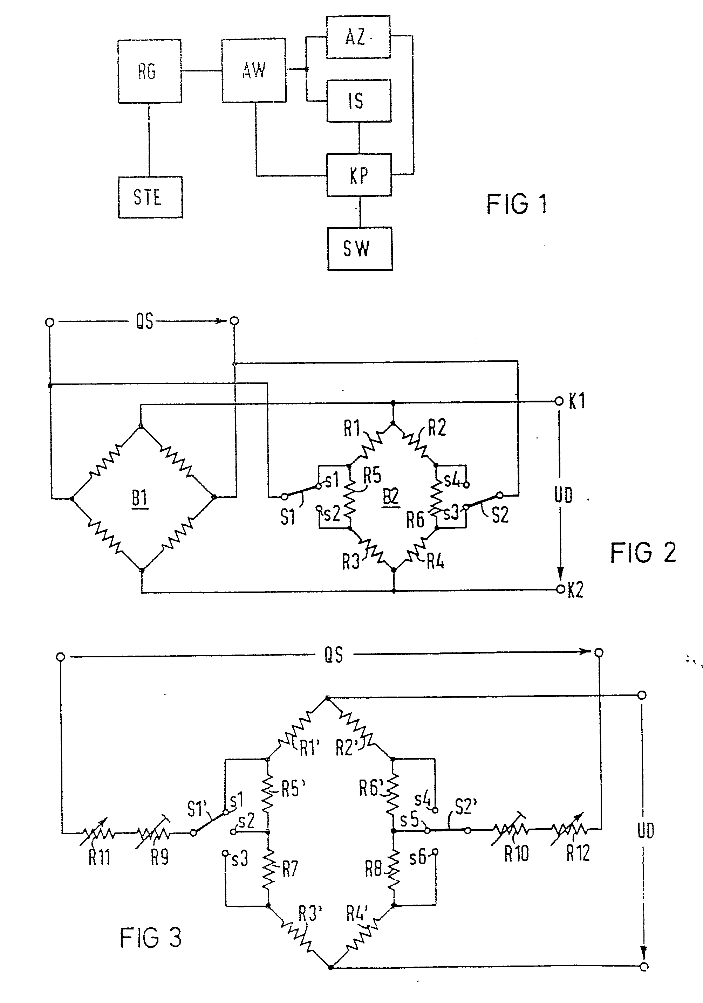

In Figur 1 ist ein Signalausgang eines Referenzsignalgebers RG mit dem Eingang einer elektronischen Auswägeeinrichtung AW verbunden. Der Ausgang der Auswägeeinrichtung AW, an dem ein Signal abgenommen werden kann, das im Betrieb eine Last abbildet, die auf einer nicht dargestellten, ebenfalls mit dem Eingang der Auswägeeinrichtung verbundenen Wägezelle ruht, ist mit Eingängen einer Anzeigeeinheit AZ und eines Istwert-Speichers IS verbunden. Vergleichseingänge eines Komparators KP sind mit Ausgängen des Istwert-Speichers IS bzw. mit Ausgängen eines Sollwert-Speichers SW verbunden. Entscheidungsausgänge des Komparators KP sind für ungleichen Ist- und Sollwert des Sollwert-Speichers SW mit einem Korrektureingang der Auswägeeinrichtung AW bzw. für ungleichen korrigierten Ist- und Sollwert des Sollwert-Speichers SW mit einem Sperreingang der Anzeigeeinheit AZ verbunden. Eine Steuereinheit STE steuert nicht dargestellte Umschalter im Innern des Referenzsignalgebers RG.

Die Wirkungsweise der Schaltungsanordnung ist hinreichend durch das Verfahren nach der Erfindung erklärt.

Ein Referenzsignalgeber nach Figur 2 besteht aus einer Widerstandsbrückenschaltung B2, deren Messdiagonalpunkte mit den Messdiagonalpunkten einer eine Wägezelle repräsentierenden Widerstandsbrückenschaltung B1 verbunden sind. Die Widerstandsbrückenschaltung B2 besteht aus zwei zur Messdiagonalen symmetrischen Brückenhälften aus jeweils drei in Serie liegenden Widerständen R1, R5, R3 bzw. R2, R6, R4. An den Anschlusspunkten der jeweils zweiten Widerstände R5 und R6 jeder Brückenhälfte liegen Kontakte s1, s2 bzw. s3 und s4, die durch Umschalter S1 bzw. S2 an eine Speisequelle QS anschliessbar sind. An der gleichen Speisequelle QS liegt auch die Speisediagonale der Widerstandsbrückenschaltung B1. An Klemmen K1 und K2 ist der Eingang der Auswägeeinrichtung AW der Figur 1 anschliessbar. In der Widerstandsbrückenschaltung B2 werden über die beiden Umschalter S1 und S2 die beiden Referenzsignale erzeugt. Liegt der Umschalter S1 am Kontakt s1 und der Umschalter S2 am Kontakt s3, so ist die Widerstandsbrückenschaltung B2 abgeglichen. Dies ist die Betriebsstellung. Wenn der Umschalter S1 am Kontakt s2 und der Umschalter S2 am Kontakt s3 liegt, so ist die Widerstandsbrückenschaltung B2 so verstimmt, dass über die Ausgleichströme eine Spannung UD an der Messdiagonalen liegt, die das erste Referenzsignal darstellt.

Über die Abweichung der Anzeige vom Sollwert wird die Empfindlichkeit der Auswägeeinrichtung korrigiert. Die korrigierte Empfindlichkeit wird dann mit der Stellung des Umschalters S1 am Kontakt s1 und des Umschalters S2 am Kontakt s4 überprüft und gegebenenfalls bestätigt oder verworfen.

Mit dieser Anordnung werden nicht nur die Bausteine der Auswägeeinrichtung einschliesslich der Umschaltkontakte überwacht, sondern wegen der direkten Verkopplung mit der Widerstandsbrückenschaltung B1 der Wägezelle auch Langzeitdriften bzw. Veränderungen in den aus Dehnungsmessstreifen zusammengesetzten Brückenschaltungen der Wägezelle erkannt. Die Widerstandsbrückenschaltung B1 kann auch durch eine Parallelschaltung mehrerer Wägezellen ersetzt werden.

In Figur 3 ist ein anderer Referenzsignalgeber dargestellt, der ebenfalls in einer Rückenschaltung B3 besteht. Die Verbindung mit einer anderen, nicht dargestellten, eine Wägezelle repräsentierenden Widerstandsbrückenschaltung ist der Einfachheit halber weggelassen. Die Widerstandsbrückenschaltung B3 besteht aus zwei zur Messdiagonalen symmetrischen Brückenhälften aus Widerständen R1', R5', R7, R3' bzw. R2', R6', R8 und R4'. Anschlusspunkte der zweiten und dritten Widerstände jeder Brückenhälfte R5', R7 bzw. R6' und R8 sind an Umschaltkontakte s1', s2', s3' eines Umschalters S1' bzw. an Umschaltkontakte s4', s5', s6' eines Umschalters S2' geführt. Die Umschalter verbinden die Kontakte und damit die entsprechenden Brückenpunkte über einstellbare Widerstände R9 und R11 bzw. R10 und R12 mit einer Speisequelle QS. An der Messdiagonalen liegt bei verstimmter Brücke eine Spannung UD an, die als Referenzsignal für den Eingang der nicht dargestellten Auswägeeinrichtung dient.

Der Brückeninnenwiderstand bleibt in den verschiedenen Schalterstellungen konstant. Die Schalterstellung Umschalter S1' an Kontakt s1' und Umschalter S2' an Kontakt s5' entspricht einer ersten Betriebsstellung. Bei der Schalterstellung S1' an s3' und S2' an s5' wird gegebenenfalls die Korrektur durchgeführt. Die Schalterstellung S1' an s2' und S2' an s4' entspricht einem Prüfvorgang nach durchgeführter Korrektur. Eine weitere Schalterstellung, bei der Umschalter S1' an Kontakt s2' und der Umschalter S2' an Kontakt s6' liegt, entspricht einer zweiten Betriebsstellung. In der ersten Betriebsstellung ist die Widerstandsbrückenschaltung um das halbe Referenzsignal negativ vorverstimmt. Ein Totalausfall eines Bauelementes, z.B. des Schalters, wird daher in dieser Betriebsstellung erkannt, weil der Fehler dann stets grösser ist als der Nullstellbereich.

Die resultierende Diagonalspannung UD wird zusammen mit einem eventuellen Totlastanteil einer nicht dargestellten, zur Widerstandsbrückenschaltung B3 parallelliegenden Wägezelle in einer ebenfalls nicht dargestellten, besonderen Totlastbrücke kompensiert, die nach beiden Seiten verstimmbar ist. So können auch Totlastanteile von weniger als dem halben Referenzsignal eliminiert werden. Die zweite Betriebsstellung kann zur weiteren Symmetrie- und Funktionskontrolle herangezogen werden. Die Widerstände R9 und R10 dienen dem Feinabgleich für das Referenzsignal. Über die Widerstände R11 und R12 kann ein Gleichlauf des Innenwiderstandes mit eventuell angeschlossenen Wägezellen bezüglich der Temperatur eingestellt werden, so dass bei einer nachgebenden Speisespannung die Stromverteilung zwischen angeschlossenen Wägezellen und Referenzsignalbrückenschaltung erhalten bleibt.

**Patentansprüche**

1. Verfahren zur Korrektur der Empfindlichkeit der Auswägeeinrichtung von elektrischen Wägeanlagen aufgrund eines Vergleichs eines von einem Referenzsignal verursachten Ausgangssignales der Auswägeeinrichtung mit einem Sollwert, dadurch gekennzeichnet, dass auf den ersten Vergleich ein weiterer Vergleich eines durch ein vom ersten unabhängiges zweites Referenzsignal hervorgerufenen Ausgangssignales der Auswägeeinrichtung mit dem Sollwert erfolgt und die Auswägeeinrichtung mit dem Sollwert erfolgt und die Auswägeeinrichtung blockiert wird, wenn das vom zweiten Referenzsignal hervorgerufene Ausgangssignal die auf dem ersten Vergleich beruhende Korrektur nicht bestätigt.

2. Verfahren nach Anspruch 1, dadurch gekennzeichnet, dass die Eingabe des Referenzsignals über manuell bedienbare Schalter erfolgt.

3. Verfahren nach Anspruch 1, dadurch gekennzeichnet, dass die Eingabe des Referenzsignals automatisch erfolgt.

4. Schaltungsanordnung zur Ausübung des Verfahrens nach Anspruch 1 oder einem der vorausgehenden Ansprüche, dadurch gekennzeichnet, dass ein Referenzsignalgeber (RG) mit den Eingangsklemmen einer Auswägeeinrichtung (AW) verbunden und der Ausgang der Auswägeeinrichtung (AW) an Eingänge eines Istwert-Speichers (IS) und einer Anzeigeeinheit (AZ) angeschlossen ist und Vergleichseingänge eines Komparators (KP) mit Ausgängen des Istwert-Speichers (IS) bzw. eines Sollwert-Speichers (SW) verbunden sind und Entscheidungsausgänge des Komparators (KP) für ungleichen Ist- und Sollwert an einem Korrektureingang der Auswägeeinrichtung (AW) und für ungleichen korrigierten Istwert und Sollwert an einem Sperreingang der Anzeigeeinheit (AZ) liegen und Umschalter innerhalb des Referenzsignalgebers (RG) mit einer Steuereinheit (STE) verbunden sind.

5. Schaltungsanordnung nach Anspruch 4, dadurch gekennzeichnet, dass ein Referenzsignalgeber aus einer Brückenschaltung mit zwei zur Messdiagonalen symmetrischen Brückenhälften aus je drei in Serie geschalteten Widerständen besteht und die Anschlusspunkte der zweiten Widerstände beider Brückenhälften über je einen Umschalter an eine Speisequelle anschliessbar sind.

6. Schaltungsanordnung nach Anspruch 4, dadurch gekennzeichnet, dass der Referenzsignalgeber aus einer Widerstandsbrückenschaltung mit zwei zur Messdiagonalen symmetrischen Brückenhälften aus je vier in Serie geschalteten Widerständen besteht und die Anschlusspunkte der zweiten und dritten Widerstände beider Hälften über je einen Umschalter und zusätzliche Abgleichwiderstände an die Speisequelle anschliessbar sind.

**Revendications**

1. Procédé pour corriger la sensibilité de dispositifs de mesure d'installations électriques de pesée, sur la base d'une comparaison d'un signal de sortie de l'installation de pesée, provoqué par un signal de référence, avec une valeur de consigne, caractérisé par le fait que la première comparaison est suivie d'une autre comparaison entre un signal de sortie de l'installation de pesée, provoqué par un second signal de référence indépendant du premier, et la valeur de consigne, et que l'installation de pesée est bloquée si le signal de sortie provoqué par le second signal de référence ne confirme pas la correction reposant sur la première comparaison.

2. Procédé selon la revendication 1, caractérisé par le fait que l'introduction di signal de référence est opérée par des commutateurs à commande manuelle.

3. Procédé selon la revendication 1, caractérisé par le fait que l'introduction du signal de référence est opérée automatiquement.

4. Montage pour la mise en œuvre du procédé selon la revendication 1 ou selon l'une des revendications précédentes, caractérisé par le fait qu'un générateur de signaux de référence (RG) est relié aux bornes d'un dispositif de pesée (AW) et la sortie du dispositifs de pesée (AW) est reliée à des entrées d'une mémoire (IS) de valeurs instantanées et d'une unité d'affichage (AZ), et que des entrées de comparaison d'un comparateur (AP) sont reliées à des sorties de la mémoire de valeurs instantanées (IS) d'une mémoire de valeurs de consigne (SW), alors que des sorties de décision du comparateur (KP) sont reliées, pour des valeurs instantanées et de consigne différentes, à une entrée de correction du dispositif de pesée (AW), et, pour des valeurs instantanées et de consigne différentes corrigées, à une entrée de blocage de l'unité d'affichage, des commutateurs dans le générateur de signaux de référence (RG) étant reliés à une unité de commande (STE).

5. Montage selon la revendication 4, caractérisé par le fait qu'un générateur de référence est constitué par un circuit en pont à deux moitiés symétriques par rapport à la diagonale de mesure, constituée respectivement par trois résistances montées en série, les points de raccordement de la seconde résistance des deux moitiés de pont étant chacune susceptible d'être reliée à une source de tension, par un commutateur.

6. Montage selon la revendication 4, caractérisé par le fait que le générateur de signaux de référence est constitué par un montage en pont à résistances, ayant deux moitiés de pont symétriques par rapport à la diagonale de mesure et dont chacune est formée par quatre résistances montées en série, alors que les points de raccordement de la seconde et de la troisième résistance des deux moitiés de pont sont respectivement susceptibles d'être reliées à la source de tension par l'intermédiaire d'un commutateur et de résistances supplémentaires de tarage.

**Claims**

1. A method of correcting the sensitivity of the balancing device of an electrical weighing system by comparing an output signal which has been produced from the balancing device by means of a reference signal with a theoretical value, characterised in that a further comparison is carried out between the theoretical value, and an output signal from the balancing device produced by a second reference signal which is independent of the first, and the balancing device is blocked when the output signal produced by the second reference signal does not confirm the correction which is based on the first comparison.

2. A method as claimed in Claim 1, characterised in that the reference signal input is via manually controllable switches.

3. A method as claimed in Claim 1, characterised in that the reference signal input is automatic.

4. A circuit arrangement for performing the method claimed in Claim 1, Claim 2 or Claim 3, characterised in that a reference signal generator (RG) is connected to the input terminals of a balancing device (AW), and the output of the balancing device (AW) is connected to inputs of an actual value store (IS) and of a display unit (AZ), that respective comparison inputs of a comparator (KP) are connected to outputs of the actual value store (IS) and of a theoretical value store (SW), and in the event of a non-identical actual and theoretical values decision outputs of the comparator (KP) are connected to a correcting input of the balancing device (AW), and connected to a blocking input of the display unit (AZ), in the event of a non-identical corrected actual value and theoretical value, and change-over switches arranged within the reference signal generator (RG) are connected to a control unit (STE).

5. A circuit arrangement as claimed in Claim 4, characterised in that a reference signal generator consists of a bridge circuit comprising two bridge halves each composed of three series connected resistors, and symmetrical to the measurement diagonal, and that the terminal points of the two resistors in each of the two halves of the bridge can each be connected to a feed source via a respective change-over switch.

6. A circuit arrangement as claimed in Claim 4, characterised in that the reference signal generator consists of a resistance bridge circuit comprising two bridge halves, each composed of four series connected resistors, and symmetrical to the measurement diagonal, and that the terminal points of the second and third resistors of each of the two halves can each be respectively connected to the feed source via a change-over switch and additional compensating resistors.

FIG 1

FIG 2

FIG 3